# EUROPEAN PATENT SPECIFICATION

(11) **EP 0 325 765 B1**
(45) Date of publication and mention of the grant of the patent: **03.03.1993**
(21) Application number: 88121155.1
(22) Date of filing: 16.12.1988
(51) Int. Cl.: H01L 39/22, H01L 39/24

(54) **Josephson device having a Josephson junction structure suitable for an oxide superconductor**
Josephson-Einrichtung, bestehend aus einer Josephson-Übergangsstruktur, welche für einen Oxidsupraleiter geeignet ist
Dispositif josephson ayant une structure josephson utilisable pour un supraconducteur d'oxyde

(30) Priority: 18.12.1987 JP 320516/87
(43) Date of publication of application: 02.08.1989
(73) Proprietor: NEC CORPORATION, Tokyo (JP)
(72) Inventor: Wada, Yoshifusa, Tokyo (JP)
(74) Representative: Glawe, Delfs, Moll & Partner

(56) References cited:
- US-A- 4 290 843
- JAPANESE JOURNAL OF APPLIED PHYSICS, vol. 26, no. 7, July 1987, pages L1248-L1250, Tokyo, JP; Y. ENOMOTO et al.: "Largely anisotropic superconducting critical current in epitaxially grown Ba2YCu3O7-gamma thin film"

## Description

### BACKGROUND OF THE INVENTION

### Field of the Invention

The present invention relates to a Josephson device and, more particularly, to a Josephson device having a Josephson junction structure suitable for an oxide superconductor.

### Description of the Related Art

A Josephson device having a metal superconductor, such as niobium, or an intermetallic compound superconductor, such as niobium nitride, has hitherto been realized by forming a tunnel barrier with an insulator or a semiconductor, such as aluminum oxide or germanium, between the two superconductors to form a Josephson junction.

On the other hand, in recent years, it has been found that there exists oxide compounds such as a Y-Ba-Cu-O compound, which exhibit superconducting properties. Oxide superconductors of this kind exhibit a transition into a superconducting state at a relatively high absolute temperature of about 40 to 90K. The superconducting characteristics, i.e., physical constants such as critical current density, critical magnetic field, and coherence length, of these high-temperature oxide superconductors greatly depend upon the crystal orientation, and show a great difference of more than ten times in those superconducting properties between the C-axis direction and the direction orthogonal to the C-axis.

These high-temperature oxide superconductors have a remarkably small coherence length of about 2 to 4 nm and tends to bring about breakdown of the superconductivity originated in an oxygen elimination in vacuo and a reaction with steam in the air. For this reason, it was very difficult to form a Josephson junction between these oxide superconductors by inserting an insulator or a semiconductor therebetween.

It is known that a thin film of a high temperature oxide superconductor exhibits superconducting properties without annealing when formed on a magnesia (MgO) or strontium titanate (SrTiO₃) crystal at a substrate temperature of 500 to 700°C with a crystal orientation determined by that of the substrate.

A Josephson device with a high-temperature oxide superconductor can be prepared by a process wherein a crack is formed in an oxide superconductor ceramic rod to develop minute weak bonds within the rod (see "Japanese Journal of Applied Physics", Vol. 26, No. 5, pp. L701-L703) or a process in which a film is formed on a strontium titanate or magnesia substrate and annealing is then conducted to give a grain boundary for use as a Josephson junction (see "Technical Report of Institute of Electronics, Information and Communication Engineers, SCE87-38, vol. 87, No. 249, pp. 73-78). Furthermore, there has been developed a SQUID which was a grain boundary formed within an oxide superconductor film as a Josephson device.

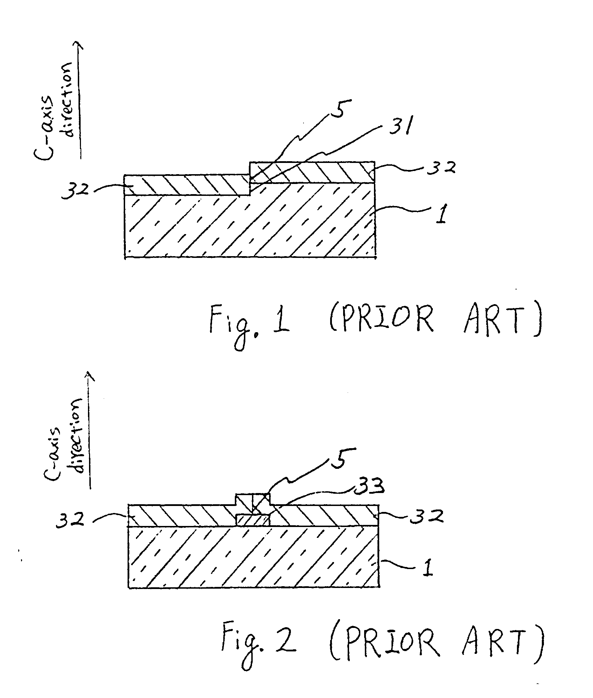

When a grain boundary is used for the Josephson device, it is necessary to form a grain boundary of a predetermined size at a predetermined position with a high accuracy. Japanese Published Unexamined Patent Application No. 62-273782 discloses a process for preparing a grain boundary within a BaPb₁₋ₓBiₓO₃ film of an oxide superconductor. Schematic cross-sectional views of structures of grain boundary junctions in BaPb₁₋ₓBiₓO₃ (hereinafter abbreviated to "BPB") films are shown in Figs. 1 and 2.

Referring to Fig. 1, a step 31 is formed on the (100) surface of a strontium titanate substrate 1, and a BPB film 32 is then grown along the C-axis direction on the whole surface of the substrate 1 to selectively grow crystal layers on both sides of the step 31. When the BPB film 32 is grown to have a thickness exceeding the height of the step 31, the crystal layers on both sides of the step 31 contact with each other to form a grain boundary therebetween, resulting in forming a Josephson junction 5.

Referring to Fig. 2, a chromium film slit 33 having a width of a few microns is formed on a (100) strontium titanate substrate 1, and a BPB film 32 is then grown along the C-axis direction on the whole surface of the substrate 1. In this case, the chromium film slit 33 is formed to have a sufficiently small width, and the BPB film 32 is grown so as to have a thickness exceeding that of the chromium film slit 33. As a result, as in the case of Fig. 1, there occurs selective crystal growth of the BPB film 32 on both sides of the chromium film slit 33. When the BPB film 32 has a sufficient thickness, the crystal layers on both sides of the chromium film slit 33 are brought into contact with each other on the slit 33 through a grain boundary, thereby forming a Josephson junction 5.

According to the conventional processes shown in Figs. 1 and 2, it is possible to prepare a grain boundary for Josephson junction on a strontium titanate substrate 1 at a predetermined place with a predetermined size.

However, in the process described in the Japanese Published Unexamined Patent Application No. 62-273782, the surface of the device becomes uneven, resulting in a problem for forming a fine and multilayered structure in the subsequent steps.

When a Josephson device is applied to a digital circuit, the operational switching speed is nearly proportional to the reciprocal of the current density at the Josephson junction. However, in this conventional technique, the area of the Josephson junction parallel to the C-axis was necessarily smaller than the thickness of the superconductor film 32, resulting in making it impossible to form a Josephson junction of a large current density, since the current density orthogonal to the C-axis is at least ten times larger than that parallel to the C-axis.

Furthermore, when the prior art shown in Fig. 2 is applied to a high-temperature oxide superconductor, there occurs another problem originated in the material for the slit film 33. In particular, in the case of a yttrium-barium-copper oxide superconductor material, each element in the superconductor is liable to diffuse into a substance existing around it to change the composition of the superconductor, resulting in a disappearance of the superconductivity.

### SUMMARY OF THE INVENTION

It is, therefore, a primary object of the present invention to provide a Josephson device having a Josephson junction with a flat surface on a predetermined position.

It is another object of the present invention to provide a Josephson device having a Josephson junction allowing a current flow of a large current density.

It is still another object of the present invention to provide a Josephson device having a Josephson junction showing a stable superconductivity.

The Josephson device in accordance with the present invention includes a crystal region having a distorted or broken lattice in a main surface of a crystal substrate or a crystal film, a ceramic oxide superconductor film epitaxially grown on said main surface of the crystal substrate or the crystal film, and a crystal boundary formed in the superconductor film at a portion on the crystal region, thereby forming a Josephson junction. The Josephson junction of the present invention can be manufactured by implanting accelerated ions into the crystal substrate or the crystal film to distort or break the crystal lattice and to form the above-described crystal region of the distorted or broken lattice. In the case of an oxide superconductor, since the elements constituting the superconductor are liable to diffuse into a substance existing around it, it is preferred to use chemically stable materials, such as gold and platinum, as the ion-implanted ions.

In the Josephson device according to the present invention, the distorted or broken-lattice crystal region is first formed in a main surface of the crystal substrate or the crystal film on which a film of a superconducting material, such as a high-temperature oxide superconductor, is to be formed. Thereafter, the film of the superconducting material is epitaxially grown thereon. The crystal structure of the crystal substrate is reflected in that of the superconductor thin film grown thereon. Therefore, the crystal structure in the superconductor film is unsettled on the distorted or broken-lattice crystal region, which suppresses the crystallization of the superconductor film. Accordingly, during the growth of the superconductor film, the crystal region of the superconductor film grown on both sides of the distorted or broken-lattice crystal region is gradually extended to the portion over the distorted or broken-lattice crystal region, to form the superconductor film having a crystal boundary only at the portion on the distorted or broken-lattice crystal region.

The Josephson device of the present invention is a device wherein a crystal boundary formed by the above-described process is used as a Josephson junction. Therefore, the position and dimension of the Josephson junction can be easily determined with high accuracy by controlling the distorted or broken-lattice region formed on the substrate crystal and the thickness or the superconducting film, resulting in stabilizing the electrical characteristics. Moreover, since the surface of the device of the present invention is flat, a desired circuit element can be formed on the device of the present invention.

Furthermore, since the superconductor film is formed flat at the portion over the distorted or broken-lattice crystal region of the crystal substrate to make the area of the Josephson junction equal to the section area of superconducting film and the crystal orientation of this superconductor film can be determined by the crystal orientation of the substrate, it is possible to form a Josephson device allowing a current flow of a large current density.

### BRIEF DESCRIPTION OF THE DRAWINGS

The above and further objects, features and advantages of the present invention will become more apparent from the following detailed description taken in conjunction with the accompanying drawings, wherein:
Fig. 1 and Fig. 2 are cross-sectional views of grain boundary Josephson junction structures dislcosed in the Japanese Published Unexamined Patent Application No. 62-273782;
Fig. 3 is a sectional view for explaining a first embodiment of the present invention; and
Fig. 4 is a sectional view for explaining a second embodiment of the present invention.

### DESCRIPTION OF THE PREFERRED EMBODIMENT

### (1st embodiment)

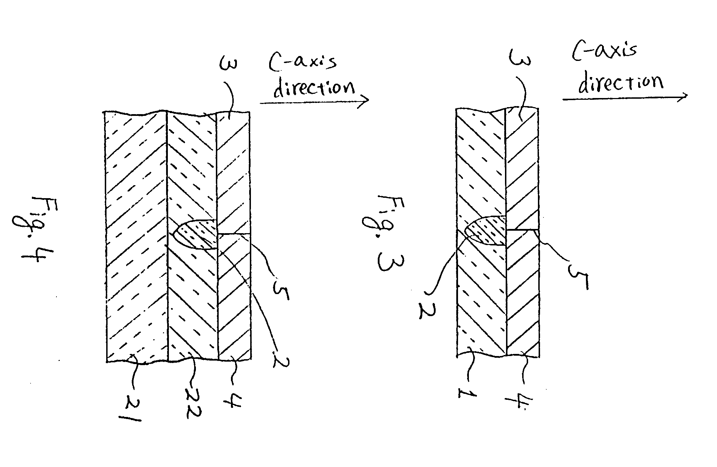

Referring to Fig. 3, the Josephson device according to the first embodiment of the present invention includes a distorted or broken-lattice crystal region 2 formed in the main the surface of a strontium titanate (SrTiO₃) single crystal substrate 1, first and second superconductor electrodes 3, 4 of yttrium-barium-copper oxides, and a Josephson junction 5 composed of a crystal boundary formed between the first superconductor electrodes 3 and the second superconductor electrode 4. A single crystal having a plane orientation (100) is used as the strontium titanate crystal substrate 1. Therefore, the yttrium-barium-copper oxide superconductor films constituting the first and second superconductor electrodes 3, 4 have a plane orientation (100) which is the same plane orientation as that of the substrate 1. Therefore, a current passing through the Josephson junction 5 flows in the direction orthogonal to the C-axis of the yttrium-barium-copper oxide superconductor films constituting the first and second superconductor electrodes 3, 4, which makes it possible to attain a Josephson junction with a current density of at least 10⁶ A/cm². For example, sufficiently large critical current value of a Josephson device, i.e., at least 0.1 mA, can be easily attained by a Josephson device with a superconductor film having a line width of 1 µm and a thickness of 0.2 µm.

This Josephson device is manufactured as follows. At the outset, gold (Au) ions having a beam diameter of 0.2 µm and accelerated by applying a voltage of 100 kV according to the focused ion beam method are implanted into a surface portion of a strontium titanate crystal (SrTiO₃) substrate 1 having the plane orientation (100) on which a Josephson device is to be formed. Part of the crystal structure or the lattice structure of the strontium titanate substrate 1 is broken by the gold ion implantation, which forms the distorted or broken-lattice crystal region 2.

Thereafter, the (100) strontium titanate single crystal substrate 1 is heated to 650°C to grow the crystal of the yttrium-barium-copper oxide (YBa₂Cu₃O₇-δ) at a growth rate of 10 nm/min. Sintered yttrium-barium-copper oxide is heated and evaporated to grow the yttrium-barium-copper oxide film with electron beams accelerated by applying a voltage of 10 kV. In order to supply a sufficient amount of oxygen to the growing film, it is preferred to irradiate oxygen ion beams accelerated with a voltage of 100 V over the whole substrate. The first and second superconductor electrodes 3, 4 are formed by growing yttrium-barium-copper oxide for 30 minutes under the above-described condition. The films of superconductor electrodes 3, 4 respectively have a crystal plane orientation (100), i.e., the same crystal plane orientation as that of the strontium titanate substrate 1. The single crystal of the first superconductor electrode 3 is grown from the left-hand side of the distorted or broken-lattice crystal region 2, whereas the single crystal of the second superconductor electrode 4 is grown from the right-hand side of the distorted or broken-lattice crystal region 2. Therefore, a crystal boundary 5 between the first and second superconductor electrodes 3 and 4 is formed on the distorted or broken-lattice crystal region 2 of the substrate 1.

Subsequently, the first and second electrodes 3 and 4 are worked into a desired shape, e.g., a 4 µm-width by exposure and etching techniques, and subjected to necessary wiring to form a Josephson device. The yttrium-barium-copper oxide film is etched by a reactive ion beam etching method wherein a chlorine gas of 10⁻³ Torr is ionized with a high-frequency plasma and then accelerated by applying a draw-out voltage of 400 V. The etching is conducted at a rate of 4 nm/min for 80 min, to pattern the superconductor electrodes 3, 4.

The superconductor films 3 and 4 may also be formed by the known film forming techniques besides the above-described process, such as D.C. sputtering and A.C. sputtering wherein an electrode of a sintered superconductor such as an yttrium-barium-copper oxide is used or a process wherein three yttrium, barium and copper electrodes are sputtered or evaporated simultaneously or in a time-sharing manner. Ion beam etching, reactive plasma etching wherein a gas other than chlorine is used, or the like may be used for working the superconductor film. It is apparent that the superconductor film forming temperature may be other than 650°C and, if necessary, may be varied in a range from 400 to 900°C. Further, it is known that magnesia (MgO) and sapphire can also be used as the substrate.

### (2nd embodiment)

Referring to Fig. 4, a strontium titanate crystal (SrTiO₃) film 22 is formed on a (100) sapphire crystal substrate 21. Sapphire is used as the substrate because a high-quality crystal substrate can be prepared therefrom at low cost. The strontium titanate film 22 is formed on the sapphire substrate 21 at a rate of 10 nm/min for 20 min to have a thickness of 200 nm according to the electron beam deposition or the like. The strontium titanate film 22 thus prepared is a single crystal having a plane orientation (100).

Thereafter, a distorted or broken-lattice crystal region 2 is formed on the surface of the strontium titanate film 22 in the same manner as that of the first embodiment. The first and second superconductor electrodes 3, 4 are then formed. The superconductor electrodes 3, 4 are prepared by forming a 300 nm-thick film of an yttrium-barium-copper oxide, a lanthanum-strontium-copper oxide [(La₁₋ₓSrₓ)₂CuO₄)], or the like. The heating of the substrate at a temperature of 600°C and irradiating of pure oxygen against the surface of the sample cause single crystal superconductors each having a plane orientation (100) to grow, resulting in the superconductor electrodes 3, 4. In this case, the oxygen pressure on the surface of the sample is set at 10 to 100 Pa. A crystal boundary is formed on the distorted or broken-lattice crystal region 2 in the strontium titanate film. Thus, there is prepared a Josephson device having a crystal boundary as the Josephson junction 5 and superconductor electrodes 3, 4. The distorted or broken-lattice crystal region 2, electrodes 3, 4 and Josephson junction 5 in this second embodiment may be prepared in the same manner as that of the first example.

A superconductor film formed on a single crystal substrate having a plane orientation (100) or on a crystal film having a plane orientation (100) according to the above-described first or second embodiments is easily grown in the form of a crystal having a plane orientation (100). Since the superconducting electrodes 3 and 4 are grown along 〈100〉 direction (i.e., C-axis direction), the Josephson junction is formed in parallel with the C-axis. Since the current density in the direction orthogonal to the C-axis is at least ten times larger than that of C-axis, the Josephson junction with large current density can be formed, resulting in the large critical current value.

The crystal film used as the underlayer on which a superconductor film is formed may also be other material than those described above, such as magnesia (MgO). It is apparent that various known combinations of substrates with crystal films can be utilized as other structures of the Josephson device wherein a crystal film is used as the underlayer on which a superconductor film is to be formed. For example, it is possible to use a Si substrate having a sapphire single crystal film formed on the surface thereof or a sapphire substrate having a SrTiO₃ film formed on the surface thereof.

## Claims

1. A Josephson device comprising :
A crystal substrate;
a distored or broken-lattice crystal region formed in a main surface of said crystal substrate;
a ceramic oxide superconductor film epitaxially grown on said main surface of said crystal substrate; and
a crystal boundary formed in said superconductor film at a portion on said distorted or broken-lattice crystal region to form a Josephson junction.

2. A Josephson device as claimed in claim 1 , wherein said distorted or broken-lattice crystal region is a region wherein the crystal lattices are distorted or broken by ion implantation.

3. A Josephson device as claimed in claim 2 , wherein said ion is Au or Pt.

4. A Josephson device as claimed in claim 1, wherein said main surface is a {100} plane.

5. A Josephson device as claimed in claim 1 , wherein said main surface is orthogonal to the C-axis of the superconductor film, said Josephson junction being parallel to said C-axis.

6. A Josephson device as claimed in claim 5, wherein said crystal substrate is selected from a group of SrTiO₃, MgO and sapphire, said oxide superconductor being selected from a group of YBa₂Cu₃O₇-δ and (La₁₋ₓSrₓ)₂CuO₄.

7. A method of manufacturing a Josephson device comprising:
A first step of implanting ions into a main surface of a crystal substrate to distort or break crystal the lattice of said crystal substrate; and
a second step of epitaxially growing a ceramic oxide superconductor film on said main surface to form a Josephson junction in said superconductor film at a portion on said distorted or broken-lattice crystal region in said main surface of said crystal substrate.

8. A method of manufacturing a Josephson device as claimed in claim 7, wherein said implanted ion is Au or Pt.

9. A method of manufacturing a Josephson device as claimed in claim 7, wherein said main surface is orthogonal to the C-axis of the superconductor film, said Josephson junction being parallel to said C-axis.

10. A method of manufacturing a Josephson device as claimed in claim 7, wherein said oxide superconductor is grown by evaporating or sputtering said oxide superconductor material.

11. A method of manufacturing a Josephson device as claimed in claim 7, wherein said oxide superconductor is formed under the presence of oxygen.

## Patentansprüche

1. Josephson-Vorrichtung mit:
Einem Kristallsubstrat,
einem verzerrten Kristallbereich oder einem Kristallbereich mit aufgebrochenem Gitter, der in einer Hauptfläche des Kristallsubstrats ausgebildet ist,
einem supraleitenden Keramikoxidfilm, der epitaktisch auf der Hauptfläche des Kristallsubstrats aufgewachsen ist, und
einer Kristallgrenze, die in dem supraleitenden Film in einem Bereich auf dem verzerrten Kristallbereich oder dem Kristallbereich mit gebrochenem Gitter ausgebildet ist, um einen Josephson-Übergang zu bilden.

2. Josephson-Vorrichtung nach Anspruch 1 , wobei der Kristallbereich, der verzerrt ist oder ein gebrochenes Gitter aufweist, ein Bereich ist, in dem Kristallgitter durch Ionenimplantation verzerrt oder aufgebrochen sind.

3. Josephson-Vorrichtung nach Anspruch 2 , wobei das Ion Au oder Pt ist.

4. Josephson-Vorrichtung nach Anspruch 1 , wobei die Hauptfläche eine {100}-Ebene ist.

5. Josephson-Vorrichtung nach Anspruch 1 , wobei die Hauptfläche orthogonal zur C-Achse des supraleitenden Films ist und wobei der Josephson-Übergang parallel zu der C-Achse ist.

6. Josephson-Vorrichtung nach Anspruch 5, wobei das Kristallsubstrat aus der Gruppe aus SrTiO₃, MgO und Saphir ausgewählt ist, wobei der Oxidsupraleiter aus einer Gruppe aus YBa₂Cu₃O₇-α und (La₁₋ₓSrₓ)₂CuO₄ ausgewählt ist.

7. Verfahren zur Herstellung einer Josephson-Vorrichtung mit:
Einem ersten Schritt der Implantierung von Ionen in eine Hauptfläche eines Kristallsubstrates, um das Kristallgitter des Kristallsubstrats zu verzerren oder aufzubrechen, und
einem zweiten Schritt zum epitaktischen Aufwachsen eines supraleitenden Keramikoxidfilms auf der Hauptfläche, um einen Josephson-Übergang in dem supraleitenden Film in einem Bereich auf dem verzerrten Kristallbereich oder dem Kristallbereich mit aufgebrochenem Gitter in der Hauptfläche des Kristallsubstrats auszubilden.

8. Verfahren zur Herstellung einer Josephson-Vorrichtung nach Anspruch 7, wobei das implantierte Ion Au oder Pt ist.

9. Verfahren zur Herstellung einer Josephson-Vorrichtung nach Anspruch 7, wobei die Hauptfläche orthogonal zur C-Achse des supraleitenden Films ist und wobei der Josephson-Übergang parallel zur C-Achse ist.

10. Verfahren zur Herstellung einer Josephson-Vorrichtung nach Anspruch 7 , wobei der Oxidsupraleiter durch Verdampfung oder Sputtern von Oxidsupraleitermaterial aufgewachsen wird.

11. Verfahren zur Herstellung einer Josephson-Vorrichtung nach Anspruch 7 , wobei der Oxidsupraleiter in Anwesenheit von Sauerstoff gebildet wird.

## Revendications

1. Dispositif Josephson comprenant :
un substrat cristallin ;
une région cristalline à réseau déformé ou rompu formée dans une surface principale du substrat cristallin ;
un film supraconducteur d'oxyde de céramique mis à croître épitaxialement sur la surface principale du substrat cristallin, et
une jonction cristalline formée dans le film supraconducteur à un emplacement sur la région cristalline à réseau déformé ou rompu pour former une jonction Josephson.

2. Dispositif Josephson selon la revendication 1, dans lequel la région cristalline à réseau déformé ou rompu est une région dans laquelle des réseaux cristallins sont déformés ou rompus par implantation ionique.

3. Dispositif Josephson selon la revendication 2, dans lequel le ion est Au ou Pt.

4. Dispositif Josephson selon la revendication 1, dans lequel la surface principale est un plan (100).

5. Dispositif Josephson selon la revendication 1, dans lequel la surface principale est perpendiculaire à l'axe C du film supraconducteur, la jonction Josephson étant parallèle à l'axe C.

6. Dispositif Josephson selon la revendication 5, dans lequel le substrat cristallin est sélectionné dans un groupe constitué de SrTiO₃, MgO et de saphir, le supraconducteur d'oxyde étant sélectionné dans un groupe constitué de YBa₂Cu₃O₇-δ et (La₁₋ₓSrₓ)₂CuO₄.

7. Procédé pour fabriquer un dispositif Josephson comprenant les étapes consistant à :
une première étape d'implantation d'ions dans une surface principale du substrat cristallin pour déformer ou rompre la structure cristalline du substrat cristallin, et
une seconde étape consistant à mettre à croître épitaxialement un film supraconducteur d'oxyde de céramique sur la surface principale pour former une jonction Josephson dans le film supraconducteur à un emplacement sur la région cristalline à réseau déformé ou rompu dans la surface principale du substrat cristallin.

8. Procédé de fabrication d'un dispositif Josephson selon la revendication 7, dans lequel le ion implanté est Au ou Pt.

9. Procédé de fabrication d'un dispositif Josephson selon la revendication 7, dans lequel la surface principale est perpendiculaire à l'axe C du film supraconducteur, la jonction Josephson étant parallèle à l'axe C.

10. Procédé de fabrication d'un dispositif Josephson selon la revendication 7, dans lequel le supraconducteur d'oxyde est mis à croître en mettant à évaporer ou en pulvérisant le matériau supraconducteur d'oxyde.

11. Procédé de fabrication d'un dispositif Josephson selon la revendication 7, dans lequel le supraconducteur d'oxyde est formé sous la présence d'oxygène.
